(19) Europäisches Patentamt
European Patent Office
Office européen des brevets

(11) Publication number: **0 105 662**
**B1**

(12) # EUROPEAN PATENT SPECIFICATION

(45) Date of publication of patent specification: **04.05.88**

(51) Int. Cl.$^4$: **H 03 K 5/02**

(21) Application number: **83305535.3**

(22) Date of filing: **20.09.83**

(54) **Buffer circuit with boot-strap circuit.**

(30) Priority: **28.09.82 JP 169054/82**

(43) Date of publication of application:
**18.04.84 Bulletin 84/16**

(45) Publication of the grant of the patent:
**04.05.88 Bulletin 88/18**

(84) Designated Contracting States:
**DE FR GB**

(56) References cited:
**EP-A-0 055 136**
**US-A-4 049 979**
**ELECTRONICS, vol.55, No.6, March 24,1982, pages 132-136, NEW YORK (US), S.SHEFFIELD EATON et al.: Circuitadvances propel 64-K RAM across the 100-ns barrier".**
**IBM TECHNICAL DISCLOSURE BULLETIN, Vol. 24, No. 9, February 1982, pages 4786-4787, NEW YORK (US), R.GRYNBERG et al.: "Clock driver with universal trigger input".**

(73) Proprietor: **FUJITSU LIMITED**
**1015, Kamikodanaka Nakahara-ku**
**Kawasaki-shi Kanagawa 211 (JP)**

(72) Inventor: **Baba, Fumio**
**Miyamaedaira Gurin-haitsu 48-303 430, Mukogaoka**
**Miyamae-ku Kawasaki-shi Kanagawa 213 (JP)**

(74) Representative: **Skone James, Robert Edmund et al**
**GILL JENNINGS & EVERY 53-64 Chancery Lane**
**London WC2A 1HN (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).



Courier Press, Leamington Spa, England.

**Description**

The present invention relates to a buffer circuit with boot-strap circuit for amplifying input signals such as clock signals.

A known buffer circuit used in integrated semiconductor circuits, e.g. in a clock generator in memory devices, charges the gate of an output metal oxide semiconductor (MOS) transistor to a voltage above a supply voltage ($V_{CC}$) so that an output signal OUT thereof rises rapidly to a voltage equal to $V_{CC}$.

A boot-strap circuit is in general provided in such a buffer circuit to charge the gate of the output MOS transistor to the high voltage. The boot-strap circuit in the buffer circuit according to the prior art, however, does not have sufficient charging capacity. Examples of such buffer circuits are described in EP—A2—0055136.

In accordance with the present invention, a buffer circuit comprises first and second output MOS transistors connected in series between a supply voltage and a ground; an output terminal connected between the first and second output MOS transistors; and a first boot-strap circuit connected to the gate of the first output MOS transistor for charging the gate of the first output MOS transistor to a voltage above the supply voltage in response to an input signal at a first logic level, so as to turn on the first output MOS transistor and to charge the output terminal to the supply voltage, the first boot-strap circuit including a capacitor and a precharging MOS transistor which precharges the capacitor, and is characterised in that the precharging transistor is connected between the supply voltage and the capacitor of the first boot-strap circuit; and in that a second boot-strap circuit having an output node is connected to the gate of the precharging MOS transistor in the first boot-strap circuit for driving the gate of the precharging MOS transistor to a voltage above the supply voltage when the input signal is at a second logic level.

The present invention provides an improved buffer circuit with an increased reset efficiency and a faster rising output signal.

Since the gate of the precharging MOS transistor in the first boot-strap circuit is driven by the second boot-strap circuit so as to precharge the capacitor in the first boot-strap circuit to a voltage above the supply voltage during a certain time, the reset efficiency of the buffer circuit can be remarkably increased and the rising speed of the output pulse signal can be increased. Furthermore, according to the present invention, these effects can be obtained just by adding a simple circuit to the prior known buffer circuit.

The invention should be contrasted with the multi-bootstrap drive described in US—A—4049979.

Two examples of buffer circuits in accordance with the present invention will now be described with reference to the accompanying drawings, in which:—

Figure 1 is a circuit diagram of one example;

Figure 2 is a waveform diagram for explaining the operation of the embodiment of Figure 1;

Figure 3 is a circuit diagram of a second example; and,

Figure 4 is a waveform diagram for explaining the operation of the embodiment of Figure 3.

Referring to Figure 1 which illustrates an embodiment of the present invention, reference symbol $BST_1$ indicates a first boot-strap circuit, and $BST_2$ indicates a second boot-strap circuit which is added according to the present invention.

First of all, the operation of a prior buffer circuit without the second boot-strap circuit $BST_2$ and, thus, with the gate of a transistor $Q_1$ directly connected to a supply voltage $V_{CC}$ is explained. In Figure 1, $Q_{10}$ to $Q_{12}$ indicate depletion-mode MOS transistors and $Q_1$ to $Q_4$ and $Q_{13}$ to $Q_{19}$ indicate enhancement-mode MOS transistors. The MOS transistor $Q_1$ and a capacitor $C_2$ constitute the first boot-strap circuit $BST_1$.

When an input signal IN applied to the gate of the MOS transistor $Q_{13}$ rises from a low logic level to a high logic level, the MOS transistor $Q_{13}$ turns on and, thus, node $N_1$ is discharged to a low logic level as shown in Fig. 2. As a result, the MOS transistor $Q_{14}$ turns off and node $N_2$ is pulled-up by the MOS transistor $Q_{11}$ to be charged to $V_{CC}$, causing the MOS transistors $Q_{15}$ to $Q_{17}$ to turn on. As the MOS transistor $Q_{16}$ turns on, node $N_6$ is discharged to a low logic level or ground. Also as the MOS transistor $Q_{17}$ turns on, output terminal OUT is discharged to ground $V_{SS}$. Furthermore, since the MOS transistor $Q_{15}$ turns on, current flows from $V_{CC}$ to $V_{SS}$ via

$$Q_1—N_4—Q_{12}—N_5—Q_{15}—N_1—Q_{13},$$

which causes node $N_5$ to be discharged to a low logic level and the MOS transistors $Q_{18}$ and $Q_{19}$ to turn off.

Node $N_4$ is boot-strapped by the capacitor $C_2$ to a voltage above $V_{CC}$ when the MOS transistor $Q_{16}$ is off, namely when the input signal IN is a low logic level. When the MOS transistor $Q_{16}$ turns on, node $N_4$ is lowered to a voltage equal to the supply voltage $V_{CC}$ minus one threshold voltage Vth of the MOS transistor $Q_1$. The capacitor $C_2$ is precharged during the turning on of $Q_{16}$. A broken line $N_4'$ in Fig. 2 shows the voltage at node $N_4$ according to the above-mentioned prior circuit. Since node $N_4$ is maintained lower by the threshold voltage Vth than $V_{CC}$ when the input signal IN is a high logic level, node $N_5$ is not charged to a sufficient voltage by boot-strapping node $N_4$ via the capacitor $C_2$ when the input signal IN falls to a low logic level, at which time node $N_1$ is charged to a high logic level, node $N_2$ is discharged to a low logic level, the transistor $Q_{14}$ turns on, and the transistors $Q_{15}$ to $Q_{17}$ turn off, causing the voltage at node $N_6$ to increase. A broken line $N_5'$ shown in Fig. 2 shows this voltage at node $N_5$. The voltage $N_5'$ at node $N_5$ causes the MOS transistor $Q_{19}$ to turn on. Therefore, if the voltage $N_5'$ at node $N_5$ is not sufficiently high

although the voltage $N_5'$ is higher than $V_{CC}$, the output signal OUT will not increase to $V_{CC}$ or it will take a lot of time to increase the output signal to $V_{CC}$.

Hereinafter, the operation of the buffer circuit according to this embodiment will be described. The present invention intends to sufficiently increase the voltage at node $N_4$ during the period when the input signal IN is maintained at a high logic level, hereinafter called the "reset period". In order to perform this operation, the embodiment of the present invention provides the second boot-strap circuit $BST_2$, whose output node $N_3$ is connected to the gate of the MOS transistor $Q_1$. A boot-strapping capacitor $C_1$ in the second boot-strap circuit $BST_2$ is connected between node $N_2$ and the output node $N_3$. It should be noted that node $N_2$ is maintained at a high logic level during the reset period. Thus, during the reset period, the gate of the MOS transistor $Q_1$ (node $N_3$) is charged to a voltage above $V_{CC}$ via the capacitor $C_1$, causing node $N_4$ to be charged to a voltage below but near $V_{CC}$ via the transistor $Q_1$ during the reset period, as shown by a solid line $N_4$ in Fig. 2. When the input signal IN falls to a low logic level from a high logic level, the voltage at node $N_2$ changes from a high logic level to a low logic level and thus node $N_3$ is discharged to a voltage below $V_{CC}$, causing the transistor $Q_1$ to turn off. At the same time, the MOS transistor $Q_{16}$ turns off, causing the voltage at node $N_6$ to increase. As a result, node $N_4$ is boot-strapped via the capacitor $C_2$ to a voltage above $V_{CC}$, and thus node $N_5$ is charged to a voltage above $V_{CC}$, as shown by a solid line $N_5$ in Fig. 2. This charged voltage at node $N_5$ is sufficiently high to drive the MOS transistors $Q_{18}$ and $Q_{19}$ and to rapidly raise the output signal OUT to $V_{CC}$.

The MOS transistor $Q_1$ is on state to charge the capacitor $C_2$ via a passage of

$$V_{CC}—Q_1—N_4—C_2—Q_{16}—V_{SS}$$

when the voltage at node $N_3$ is above $V_{CC}$. When the transistor $Q_{14}$ turns on and, thus, the transistor $Q_{16}$ turns off, thus when $N_3 \leqq V_{CC}$ and $N_4 > V_{CC}$, the MOS transistor $Q_1$ turns off, whereby node $N_4$ can be prevented from being discharged to $V_{CC}$.

Besides the boot-strapping capacitor $C_2$ and the enhancement-mode MOS transistor $Q_2$ connected as a diode for precharging the capacitor $C_2$, the second boot-strap circuit $BST_2$ preferably includes the enhancement-mode MOS transistor $Q_3$ connected as a diode between node $N_3$ and $V_{CC}$. The transistor $Q_3$, whose drain and gate are connected to node $N_3$ and whose source is connected to $V_{CC}$, prevents node $N_3$ from being overcharged. Namely, this transistor $Q_3$ clamps node $N_3$ to a voltage which is higher than $V_{CC}$ by a predetermined voltage. As a result, if $V_{CC}$ decreases when the output signal OUT rises, since the maximum voltage at node $N_3$ decreases depending upon $V_{CC}$, the transistor $Q_1$ will not turn on, causing node $N_4$ not to discharge to $V_{CC}$.

Furthermore, the second boot-strap circuit $BST_2$ preferably includes the MOS transistor $Q_4$, which is connected between node $N_3$ and $V_{CC}$ and controlled by the voltage at node $N_4$. This transistor $Q_4$ prevents node $N_4$ from being overcharged and also ensures cutting off operation of the transistor $Q_1$. The transistor $Q_1$ should be cut off during a period when the voltage at node $N_4$ is above $V_{CC}$. Therefore, if the transistor $Q_4$ is conductive during this period, the voltage at node $N_3$ is clamped to $V_{CC}$. As a result, the transistor $Q_1$ can be certainly turned off even if $V_{CC}$ drops.

Figure 3 illustrates another embodiment of the present invention. In this embodiment, the drain of the MOS transistor $Q_{14}$ is connected to node $N_4$ and furthermore to the gates of the transistors $Q_{18}$ and $Q_{19}$. The boot-strapping capacitor $C_1$ in the second boot-strap circuit $BST_2$ is connected between node $N_4$ and node $N_3$. The drain (node $N_5$) of the MOS transistor $Q_{15}$ is connected to the gates of the MOS transistors $Q_{16}$ and $Q_{17}$. Node $N_5$ is also connected via the MOS transistor $Q_{12}$ to node $N_3$. The remainder of this embodiment is essentially the same as that of the embodiment of Fig. 1.

Hereinafter the operation of the buffer circuit according to the embodiment of Fig. 3 will be described. When the input signal IN rises to a high logic level from a low logic level, the MOS transistor $Q_{13}$ turns on and thus node $N_1$ is gradually discharged to $V_{SS}$ as shown in Fig. 4. As a result, the MOS transistor $Q_{14}$ turns off and thus node $N_4$ is charged causing the voltage at node $N_3$ to be boot-strapped by the capacitor $C_1$ to a voltage high above the supply voltage $V_{CC}$ as shown in Fig. 4. Therefore, the MOS transistor $Q_1$ is maintained in on-state and node $N_4$ is charged nearly to $V_{CC}$. When node $N_4$ is charged to a voltage equal to the voltage at node $N_1$ plus one threshold voltage $V_{th}$, the MOS transistor $Q_{15}$ turns on causing node $N_5$ to be discharged as shown in Fig. 4. Thus, the MOS transistor $Q_{12}$ also turns on causing node $N_3$ to rapidly discharge. Accordingly, the MOS transistors $Q_1$ and $Q_{16}$ turn off. Since, in this case, the MOS transistor $Q_{18}$ is in on-state, node $N_6$ is boot-strapped to a voltage near to $V_{CC}$. As a pulse-shaped voltage produced by boot-strapping is applied to node $N_4$ via the capacitor $C_2$, node $N_4$ is charged to a voltage highly above $V_{CC}$. This charged voltage at node $N_4$ is sufficiently high to drive the MOS transistors $Q_{18}$ and $Q_{19}$ and to rapidly rise the output signal OUT to $V_{CC}$. Since the MOS transistor $Q_1$ is in off-State in this case, node $N_4$ can be prevented from being discharged to $V_{CC}$.

**Claims**

1. A buffer circuit comprising first and second output MOS transistors ($Q_{19}$, $Q_{17}$) connected in series between a supply voltage ($V_{CC}$) and a ground ($V_{SS}$); an output terminal (OUT) connected between the first and second output MOS transistors ($Q_{19}$, $Q_{17}$); and a first boot-strap circuit ($BST_1$) connected to the gate of the first output

MOS transistor ($Q_{19}$) for charging the gate of the first output MOS transistor to a voltage above the supply voltage in response to an input signal (IN) at a first logic level so as to turn on the first output MOS transistor and to charge the output terminal (OUT) to the supply voltage, the first boot-strap circuit including a capacitor ($C_2$) and a precharging MOS transistor ($Q_1$) which precharges the capacitor characterised in that the precharging transistor ($Q_1$) is connected between the supply voltage ($V_{CC}$) and the capacitor ($C_2$) of the first boot-strap circuit ($BST_1$); and in that a second boot-strap circuit ($BST_2$) having an output node ($N_3$) is connected to the gate of the precharging MOS transistor ($Q_1$) in the first boot-strap circuit ($BST_1$) for driving the gate of the precharging MOS transistor to a voltage above the supply voltage when the input signal is at a second logic level.

2. A buffer circuit according to claim 1, wherein the second boot-strap circuit ($BST_2$) includes a capacitor ($C_1$) which is precharged when the input signal (IN) is at the first logic level.

3. A buffer circuit according to claim 1 or claim 2, wherein the second boot-strap circuit ($BST_2$) includes diode means ($Q_3$) connected between the supply voltage ($V_{CC}$) and the output node ($N_3$) thereof for clamping the output node to a voltage which is higher than the supply voltage by a predetermined amount.

4. A buffer circuit according to claim 3, wherein the diode means ($Q_2$) comprises a MOS transistor whose gate and drain are connected to the output node ($N_3$) and whose source is connected to the supply voltage ($V_{CC}$).

5. A buffer circuit according to any of the preceding claims, wherein the second boot-strap circuit ($BST_2$) includes clamping means ($Q_4$) for maintaining the output node ($N_3$) at the supply voltage ($V_{CC}$) when a junction node ($N_4$) between the precharging MOS transistor ($Q_1$) and the capacitor ($C_2$) in the first boot-strap circuit ($BST_1$) is above the supply voltage.

6. A buffer circuit according to claim 5, wherein the clamping means comprises a MOS transistor ($Q_4$) whose source and drain are connected to the output node ($N_3$) and the supply voltage ($V_{CC}$) respectively and whose gate is connected to the junction node ($N_4$).

7. A buffer circuit according to any of the preceding claims, the circuit having a single input port to which the input signal (IN) is fed, the input port being defined by the gate of an input MOS transistor ($Q_{13}$) connected to the first boot-strap circuit ($BST_1$).

**Patentansprüche**

1. Pufferschaltung mit ersten und zweiten Ausgangs-MOS-Transistoren ($Q_{19}$, $Q_{17}$), die in Reihe zwischen einer ersten Spannungsversorgung ($V_{CC}$) und Erde ($V_{SS}$) verbunden sind; einem Ausgangsanschluß (OUT), der zwischen dem ersten und zweiten Ausgangs-MOS-Transistor ($Q_{19}$, $Q_{17}$) verbunden ist; und einer ersten Boot-strap-Schaltung ($BST_1$), die mit dem Gate des ersten Ausgangs-MOS-Transistors ($Q_{19}$) verbunden ist, um das Gate des ersten Ausgangs-MOS-Transistors auf eine Spannung oberhalb der Versorgungsspannung aufzuladen, in Abhängigkeit von einem Eingangssignal (IN) auf einem ersten logischen Pegel, um so den ersten Ausgangs-MOS-Transistor einzuschalten und den Ausgangsanschluß (OUT) der Versorgungsspannung aufzuladen, wobei die erste Boot-strap-Schaltung einen Kondensator ($C_2$) und einen Vorlade-MOS-Transistor ($Q_1$) umfaßt, welcher den Kondensator vorlädt, dadurch gekennzeichnet, daß der Vorladetransistor ($Q_1$) zwischen der Versorgungsspannung ($V_{CC}$) und dem Kondensator ($C_2$) der ersten Boot-strap-Schaltung ($BST_1$) verbunden ist; und daß eine zweite Boot-strap-Schaltung ($BST_2$) einen Ausgangsverbindungspunkt ($N_3$) hat, der mit dem Gate des Vorlade-MOS-Transistors ($Q_1$) in der ersten Boot-strap-Schaltung ($BST_1$) verbunden ist, um das Gate des Vorlade-MOS-Transistors auf eine Spannung oberhalb der Versorgungsspannung aufzuladen, wenn das Eingangssignal auf einem zweiten logischen Pegel ist.

2. Pufferschaltung nach Anspruch 1, bei der die zweite Boot-strap-Schaltung ($BST_2$) einen Kondensator ($C_1$) umfaßt, der vorgeladen wird, wenn das Eingangssignal (IN) auf einem ersten logischen Pegel ist.

3. Pufferschaltung nach Anspruch 1 oder 2, bei der die zweite Boot-strap-Schaltung ($BST_2$) eine Diodeneinrichtung ($Q_3$) umfaßt, die zwischen der Versorgungsspannung ($V_{CC}$) und dem Ausgangsverbindungspunkt ($N_3$) davon verbunden ist, um den Ausgangsverbindungspunkt auf einer Spannung zu klammern, welche um einen vorbestimmten Betrag höher als die Versorgungsspannung ist.

4. Pufferschaltung nach Anspruch 3, bei der die Diodeneinrichtung ($Q_2$) einen MOS-Transistor umfaßt, dessen Gate und Drain mit dem Ausgangsverbindungspunkt ($N_3$) verbunden sind, und dessen Source mit der Versorgungsspannung ($V_{CC}$) verbunden ist.

5. Pufferschaltung nach einem der vorhergehenden Ansprüche, bei der die Boot-strap-Schaltung ($BST_2$) eine Klammereinrichtung ($Q_4$) umfaßt, um den Ausgangsverbindungspunkt ($N_3$) auf einer Versorgungsspannung ($V_{CC}$) zu halten, wenn ein Koppelverbindungspunkt ($N_4$) zwischen dem Vorlade-MOS-Transistor ($Q_1$) und dem Kondensator ($C_2$) in der ersten Boot-strap-Schaltung ($BST_1$) oberhalb einer Versorgungsspannung ist.

6. Pufferschaltung nach Anspruch 5, bei der die Klammereinrichtung einen MOS-Transistor ($Q_4$) umfaßt, dessen Source und Drain mit dem Ausgangsverbindungspunkt ($N_3$) bzw. der Versorgungsspannung ($V_{CC}$) verbunden ist, und dessen Gate mit dem Koppelverbindungspunkt ($N_4$) verbunden ist.

7. Pufferschaltung nach einem der vorhergehenden Ansprüche, welche Schaltung einen einzigen Eingangsanschluß hat, dem das Eingangssignal (IN) zugeführt wird, welcher Eingangsanschluß durch das Gate eines Eingangs-MOS-Tran-

sistors ($Q_{13}$) definiert ist, der mit der ersten Boot-strap-Schaltung ($BST_1$) verbunden ist.

**Revendications**

1. Circuit tampon comprenant un premier et un second transistor MOS ($Q_{19}$, $Q_{17}$) de sortie connectés en série entre une tension d'alimentation ($V_{CC}$) et une masse ($V_{SS}$); une borne de sortie (OUT) connectée entre le premier et le second transistor MOS de sortie ($Q_{19}$, $Q_{17}$); et un premier circuit à réaction régéneratrice ($BST_1$) connecté à la grille du premier transistor MOS de sortie ($Q_{19}$) pour charger la grille dudit premier transistor MOS de sortie à une tension au-dessus de la tension d'alimentation en réponse à un signal d'entrée (IN) à un premier niveau logique de manière à débloquer le premier transistor MOS de sortie et à charger la borne de sortie (OUT) à la tension d'alimentation, le premier circuit à réaction régénératrice comportant un condensateur ($C_2$) et un transistor MOS de charge préalable ($Q_1$) qui charge préalablement le condensateur, caractérisé en ce que le transistor de charge préalable ($Q_1$) est connecté entre la tension d'alimentation ($V_{CC}$) et le condensateur ($C_2$) du premier circuit à réaction régénératrice ($BST_1$); et en ce qu'un second circuit à réaction régénératrice ($BST_2$) ayant un point commun de sortie ($N_3$) est connecté à la grille du transistor MOS de charge préalable ($Q_1$) dans le premier circuit à réaction régénératrice ($BST_1$) pour attaquer la grille du transistor MOS de charge préalable à une tension au-dessus de la tension d'alimentation quand le signal d'entrée est à un second niveau logique.

2. Circuit tampon selon la revendication 1, dans lequel le second circuit à réaction régénératrice ($BST_2$) comporte un condensateur ($C_1$) qui est chargé préalablement quand le signal d'entrée (IN) est au premier niveau logique.

3. Circuit tampon selon la revendication 1 ou la revendication 2, dans lequel le second circuit à réaction régénératrice ($BST_2$) comporte une diode ($Q_3$) connectée entre la tension d'alimentation ($V_{CC}$) et le point commun de sortie ($N_3$) pour verrouiller le point commun de sortie à une tension qui est supérieure à la tension d'alimentation d'une valeur prédéterminée.

4. Circuit tampon selon la revendication 3, dans lequel la diode ($Q_2$) consiste en un transistor MOS dont la grille et le drain sont connectés au point commun de sortie ($N_3$) et dont la source est connectée à la tension d'alimentation ($V_{CC}$).

5. Circuit tampon selon l'une quelconque des revendications précédentes, dans lequel le second circuit à réaction régénératrice ($BST_2$) comporte un dispositif de verrouillage ($Q_4$) destiné à maintenir le point de sortie ($N_3$) à la tension d'alimentation ($V_{CC}$) lorsqu'un point commun de jonction ($N_4$) entre le transistor MOS de charge préalable ($Q_1$) et le condensateur ($C_2$) dans le premier circuit à réaction régénératrice ($BST_1$) est au-dessus de la tension d'alimentation.

6. Circuit tampon selon la revendication 5, dans lequel le dispositif de verrouillage consiste en un transistor MOS ($Q_4$) dont la source et le drain sont connectés respectivement au point commun de sortie ($N_3$) et à la tension d'alimentation ($V_{CC}$) et dont la grille est connectée au point commun de jonction ($N_4$).

7. Circuit tampon selon l'une quelconque des revendications précédentes, ce circuit ayant une seule connexion d'entrée à laquelle est appliqué le signal d'entrée (IN), la connexion d'entrée étant définie par la grille d'un transistor MOS d'entrée ($Q_{13}$) connecté au premier circuit à réaction régénératrice ($BST_1$).

Fig. 1

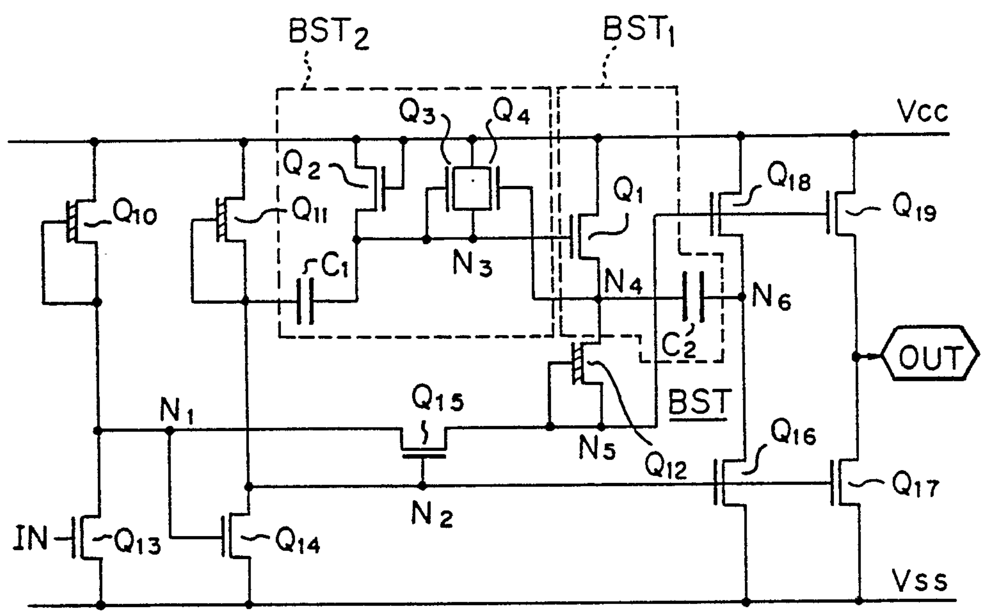
BST2
BST1
Vcc
Q3
Q4
Q2
Q1
Q18
Q19
Q10
Q11
C1
N3
N4
N6
C2
OUT
BST
N1
Q15
N5
Q12
Q16
Q17
N2
IN
Q13
Q14
Vss

Fig. 2

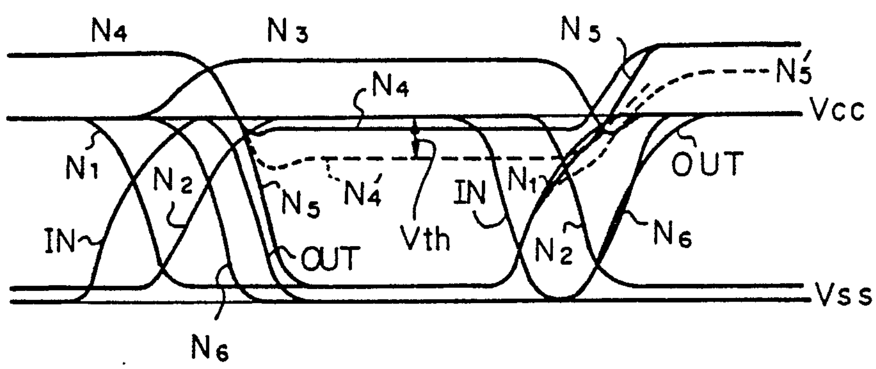
N4
N3
N5
N5'
Vcc
N4
N1
N2
N5
N4'
Vth
IN
N1
OUT
IN
OUT
N2
N6
Vss
N6

Fig. 3

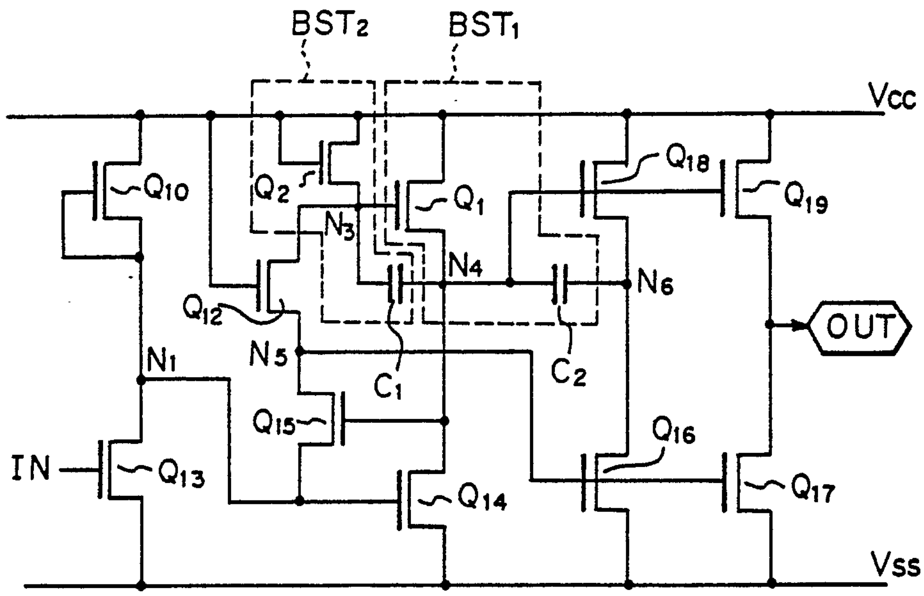
BST2
BST1
Vcc
Q10
Q2
Q1
Q18
Q19
N3
N4
N6
Q12
N5
C1
C2
OUT
N1
Q15
Q16
IN
Q13
Q14
Q17
Vss

Fig. 4

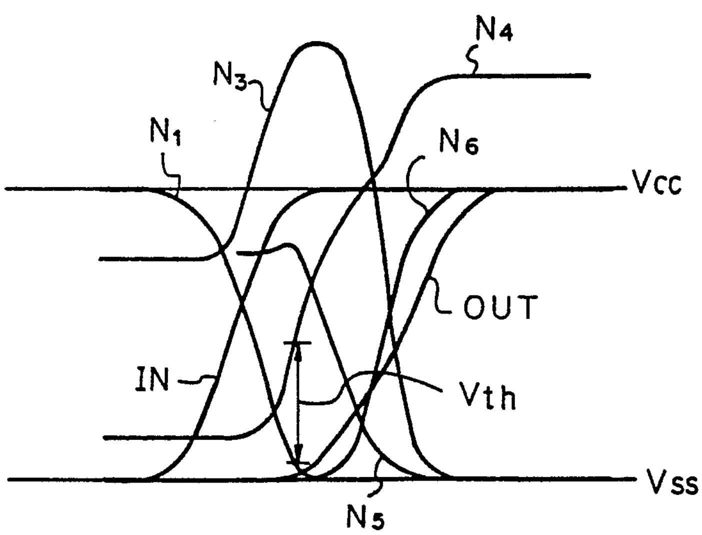
N4
N3
N1
N6
Vcc
OUT
IN
Vth
Vss
N5